# EUROPEAN PATENT APPLICATION

(11) **EP 0 629 008 A1**
(43) Date of publication of application: **14.12.1994**
(21) Application number: 94903110.8
(22) Date of filing: 28.12.1993
(51) Int. Cl.: H01L 49/02

(54) **STRUCTURE OF MIM DIODE AND METHOD FOR ITS MANUFACTURE**

(30) Priority: 28.12.1992 KR 9225683
(71) Applicant: ORION ELECTRIC CO., LTD., Kumi-shi, Kyungsangbuk-do 730-030 (KR)
(72) Inventor: KIM, Sung Hwan, Kangdong-gu, Seoul 134-081 (KR)
(74) Representative: Schmidt, Horst, Dr.
(86) International application number: KR9300117
(87) International publication number: WO9415370

(57) **Abstract**

This diode is used for a liquid crystal display of an active matrix type. The parasitic capacitance of the diode can be reduced, and a film with a large area and an even thickness can be formed, making it possible to fabricate a large liquid crystal display. An MIM diode has a structure made up of a metal layer for the lead-in electrode which is connected to a data bus, an ITO layer for the transparent electrode for forming a pixel, a metal layer for an electrode connecting the metal layer for the lead-in electrode, and the ITO layer, and an insulating layer between the metal layers for the lead-in electrode and connecting electrode. In this diode, a layer of porous aluminium oxide p-Al₂O₃ is formed between the insulating layer and the metal layer for connecting electrode.

## Description

### Field of Invention

The invention relates to active matrix type of liquid crystal display (LCD) and, more particularly, to metal-insulator-metal (MIM) diode structure used as switching elements for liquid crystal display and the method for manufacturing the same.

### Background of Invention

A liquid crystal display, using liquid crystal material having light transmission index and refraction index which are changed according to changes in electric field, magnetic field or temperature, is small and light, can be operated by low voltage and has a relatively low power consumption; hence, it has various applications.

In order for the liquid crystal to display precise pictures, it requires plurality of pixels and therefore, the liquid crystal display is constructed as matrix type, which is composed of plurality of signal electrodes (X electrodes) and scanning electrodes (Y electrodes). The X and Y electrodes are arranged to intersect each other and at intersection points, liquid crystal molecules are selectively lit with time differences by applying voltage between both electrodes.

However, this simple matrix type has a limitation: the duty cycle can not be increased and therefore, can not display precise pictures because of the so called cross-talk phenomena i.e. voltage is applied to non-selected intersection points according to increase of the number of scanning electrodes.

In order to overcome this limitation, it has been developed a liquid crystal display of an active matrix type in which switching elements for switching liquid crystal molecules are arranged as matrix shape. The active matrix type is generally divided into two types, one type using thin film transistor and the other type using diode. MIM diode structure is widely utilized for the diode type.

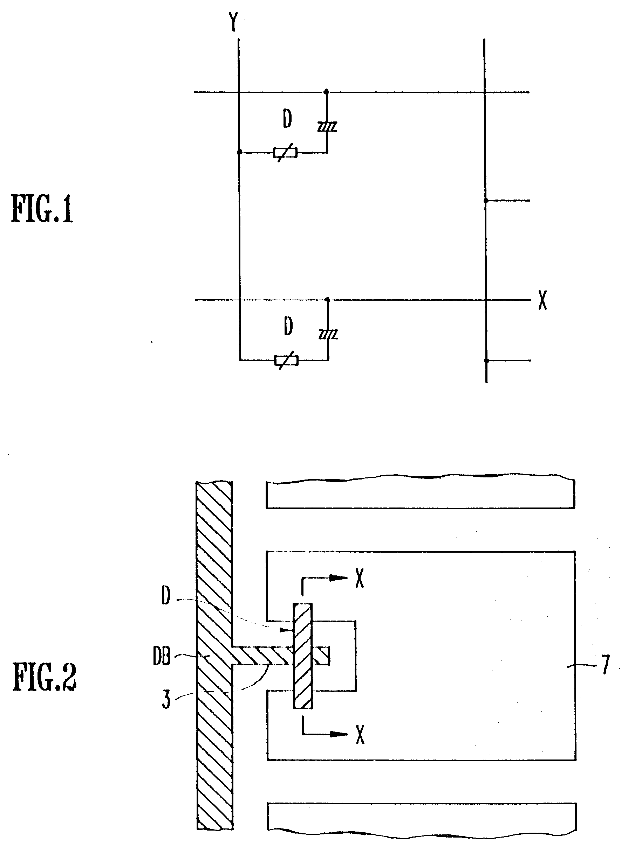

The MIM diode structure utilizes the property that a thin film comprising tantalum oxide (Ta₂O₅) shows very nonlinear current-voltage property. An shown in Fig. 1, MIM diode D switches to cause liquid crystal molecules corresponding to selected pixels excited only when the pixels to become are selected by signal electrodes X arid scanning electrodes Y and are applied by greater voltage than the threshold voltage. The resistance of non-selected pixels becomes high, so that liquid crystals serve as capacitors and accordingly, this structure has memory capability to store the picture until the next operating voltage is applied.

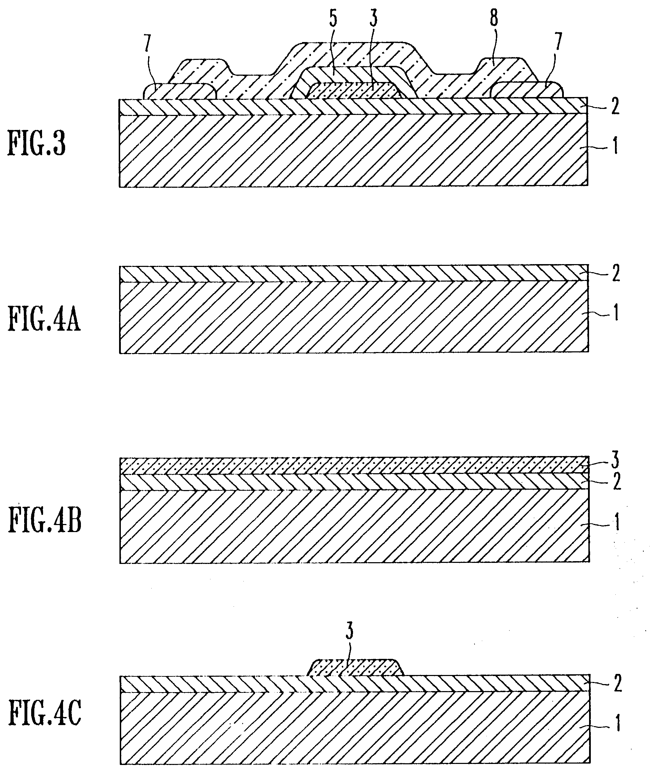

An active matrix type of liquid crystal display using conventional MIM diode structure is illustrated in Fig. 2. As shown in Fig. 2, a transparent electrode **7**, which is comprised of indium tin oxide (ITO) to form the pixels, is connected to lead-in electrode **3** of data bus (DB) through a MIM diode D. Fig. **3** is a cross section view taken along the line A-A in Fig. 2. As shown in Fig. 3, a buffer layer **2**, which utilizes tantalum oxide (Ta₂O₅) and is used for a barrier layer, is formed on a circuit board **1**, and a transparent electrode **7** utilizing ITO and a lead-in electrode **3** utilizing tantalum (Ta) are formed on the buffer layer **2** with particular spacing. Further, an insulating layer **5** utilizing tantalum oxide is formed on the lead-in electrode **3** and a connecting electrode **8** utilizing chromium (Cr) is formed on the entire structure to construct a MIM diode.

However, a MIM diode of Ta-Ta₂O₅-Cr layers structure is to form a parasitic capacitor since the tantalum oxide (Ta₂O₅) that is used for insulating layer **6** has high dielectric constant (εr=26). Therefore, time in wasted to charge the parasitic capacitor before starting the pixel, so that operating speed of the pixels becomes slow and voltage changes for operating pixels are large. These demerits result in deterioration on of the picture quality of the liquid crystal display using the MIM diode structure and limitation to make display information in high density.

In order to solve these problems, it was suggested a lateral MIM diode structure, which uses polyimide as insulating layer in place of tantalum oxide of high dielectric constant and therefore, reduces the parasitic capacitance. However, polyimide is difficult to fabricate in large area and to be formed in uniform thickness so polyimimde has not been suitable to fabricate a large liquid crystal display.

Accordingly, the invention has the objective of providing a MIM diode structure which form a film over a large area with uniform thickness, and a method for manufacturing the same.

### Disclosure of Invention

In order to achieve this objective, the MIM diode structure of the invention features a layer of porous aluminum oxide which is formed between an insulating layer and a metal layer for a connecting electrode.

The method for manufacturing the MIM diode of the invention comprises of a step to form a buffer layer on the circuit board; a step to laminate the first and the second metal layers on the buffer layer, and etch and pattern them as a data bus and a lead-in electrode; a step to anodize the first and second metal layers, and form a duplex insulating layer of a layer of Ta₂O₅ and a layer of p-Al₂O₃, oil the patterned first metal layer; a step to laminate and etch ITO layer on the insulating layer to form a transparent electrode; and a step to laminate and etch a third metal layer to patternize it as a connecting electrode shape.

### Brief Description of the Drawings

The invention will now be described by way of example with reference to the accompanying drawings in which:
Fig. 1 is an equivalent circuit diagram of an active matrix type of liquid crystal display.
Fig. 2 is a top plane view of liquid crystal display utilizing a conventional MIM diode structure.
Fig. 3 is a cross section view of the conventional MIM diode structure taken along the line X-X in Fig. 2.
Fig. 4A to 4J are cross section views useful for explaining an embodiment of the present invention.
Fig. 5A and 5B are cross section views useful for explaining another embodiment of the present invention.

### Detailed Description of the Invention

Figures 4A to 4J are cross section views for illustrating a manufacturing method of a MIM diode according to the present invention.

Fig. 4A is a cross section view showing that a buffer layer 2 of tantalum oxide (Ta₂O₅) on the circuit board **1** is formed by heat growth step.

Fig. 4B is a cross section view showing that a first metal layer **3** of tantalum for lead-in electrode is formed on the buffer layer **2**, for example by thickness of 20nm.

Fig. 4C is a cross section view showing that the first metal layer **3** has been patternized by a mask step and a etching step. A dry etching method, such as plasma etching or electronic beam etching, etc, is preferable to the etching step, but a wet etching method also may be used.

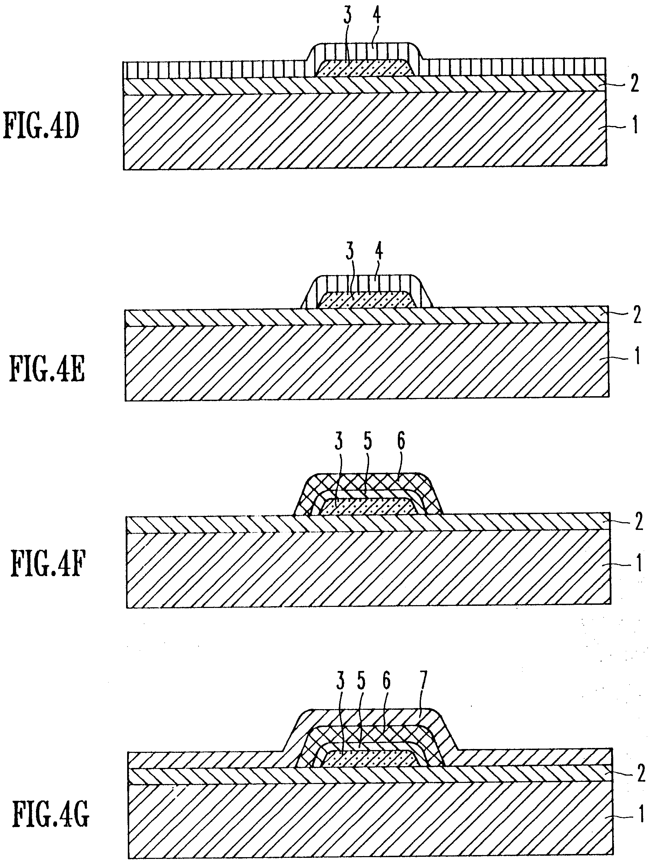

Fig. 4D is a cross section view showing that a second metal layer **4** of aluminum is formed on the exposed buffer layer **2** and the patternized first metal layer, for example by thickness of 400nm.

Fig. 4E is a cross section view showing that the second metal layer **4** has been patternized by a mask step and a etching step. Fig. 4F is a cross section view showing that a tantalum oxide (Ta₂O₅) layer **5** and a porous p-Al₂O₃ layer **6** are formed on the patternized first metal layer **3** by anodizing the patternized first and second metal layers **3** and **4**. In the anodization step, a method to apply voltage to the first metal layer **3** in 4% phosphoric acid solution is preferable., however, a citric acid solution may be also used instead. The thickness of p-Al₂O₃ layer **6** which is formed by the anodization is preferable(e.g., 500nm) and the thickness of the Ta₂O₅ layer **5** which is anodized and formed on the surface of the patternized first metal layer **3** is preferably about one tenth of that of the p-Al₂O₃ layer **6**(e.g., 50nm).

Fig. 4G is a cross section view showing that an ITO layer **7** is formed on the exposed buffer layer **2** and the p-Al₂O₃ layer **6**. Fig. 4H is a cross section view showing that the ITO layer 7 has been patternized by mask and etching steps.

Fig. 4I is a cross section view showing that a third metal layer **8** for a connecting electrode such as cromium has been formed on the exposed buffer layer **2**, the patternized ITO layer **7** and the p-Al₂O₃ layer **6**. Fig. 4J is a cross section view showing that a portion of the third metal layer **8** on the patternized ITO layer **7** has been eliminated. The MIM diode is completed by electrically connecting electrically the first metal layer **3** to the ITO layer **7**.

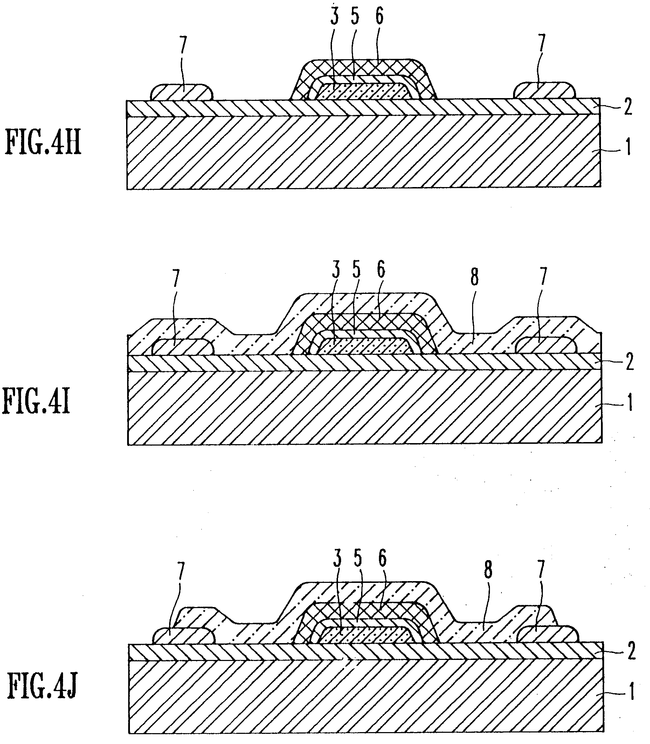

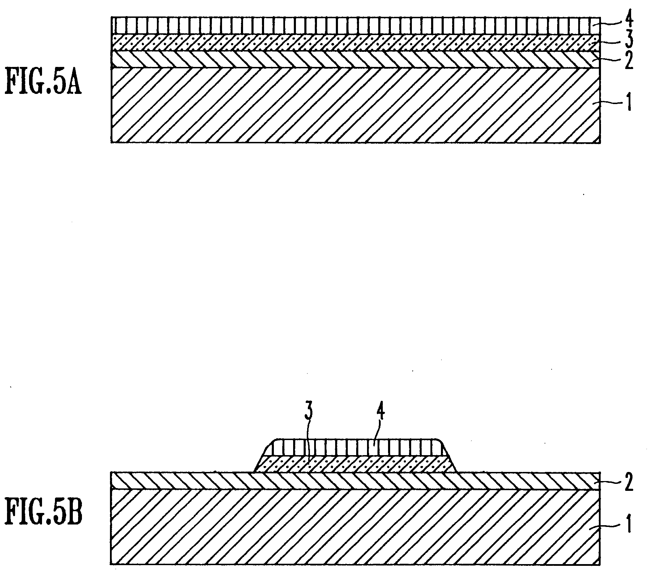

Fig. 5A and 5B are cross section views useful for explaining another embodiment of the present invention.

Fig. 5A is a cross section, view showing that a buffer layer **2**, a first metal layer 3 and a third metal layer **4** have been formed on a circuit board **1** subsequently. Fig. 5B is a cross section view showing that the first and second layers **3** and **4** have formed the desired pattern by mask and etching steps. After completing the patterning step shown in Fig. 5B, the anodization step shown in Fig. 4F will be followed.

As described in the embodiments of the present invention, an insulating layer of duplex structure in which the Ta₂O₅ layer **5** is completely enclosed by the p-Al₂O₃ layer **6** is formed. In order to form this structure, it is preferable that when the p-Al₂O₃ layer **6** is formed, the second metal layer **4** should be formed by a separate step other than the step to form the first metal layer **3** however, as shown in Fig. 5A and 5B, it is also possible to laminate the first metal layer **3** and the second metal layer **4**, subsequently and etch both layers simultaneously to form an insulating layer. In the embodiments of the present invention, between the third metal layer **8** for a connecting electrode and the first metal layer **3** for a lead-in electrode are insulated therebetween with the plane surfaces having large contact area by a thick p-Al₂O₃ layer **6** and a relatively thin Ta₂O₅ layer **5** and with the side surfaces having relatively small contact area by a thick Ta₂O₅ layer **5**. The other embodiment described with reference to Fig. 5A and 5B has a slightly increased parasitic capacitance more than that of the embodiment of Fig. 4A to 4J, however, it also has a remarkably reduced parasitic capacitance rather than that of the prior art because the plane surfaces having large contact area have been insulated by the p-Al₂O₃ layer **6** having a lower dielectric constant.

As described above, in the MIM diode of the present invention, the Ta₂O₅ layer (εr=26) having a high dielectric constant is enclosed by a relatively thick p-Al₂O₃ layer (εr=7) having a low dielectric constant so that the parasitic capacitance of the MIM diode structure is remarkably reduced and therefore, the response time of pixels becomes short, and the changes in operating voltage is prevented. Further, the structure forms a large area with uniform thickness compared to the polyimide structure; therefore, a large liquid crystal display may be fabricated.

In addition, a liquid crystal display of high picture quality and high information density can be constructed by utilizing the MIM diode structure of the present invention.

## Claims

1. A MIM diode structure comprising of a metal layer for a lead-in electrode which is connected to a data bus, an ITO layer for a transparent electrode which composes pixels, a metal layer for a connecting electrode which connects said metal layer for the lead-in electrode and said ITO layer and an insulating layer which is formed between said metal layer for the lead-in electrode and said metal layer for the connecting electrode characterized in that a porous aluminum oxide (p-Al₂O₃) layer is formed between said insulating layer and said metal layer for the connecting electrode.

2. The MIM diode structure as claimed in claim 1, characterized in that said aluminum oxide layer, is formed by enclosing the entire contact surfaces of said metal layer for the connecting electrode.

3. The MIM diode structure as claimed in claim 1, characterized in that said aluminum oxide layer, is formed only on the plane surface of the contact surfaces between said metal layer for the connecting electrode and said insulating layer.

4. A method for manufacturing a MIM diode comprising:
step to form a buffer layer on a circuit board;
step to laminate a first metal layer and a second metal layer and etch and patternize them as data bus and lead-in electrode shapes;
step to form a duplex insulating layer of a Ta₂O₅ layer and a p-Al₂O₃ layer on the first metal layer which is patternized by anodizing said first and second metal layers;
step to laminate and etch an ITO layer on said insulating layer forming a transparent electrode; and
step to laminate, etch and patternize a third metal layer as a connecting electrode on said duplex insulating layer and said transparent electrode.

5. The method as claimed in claim 4, characterized in that said second metal layer is laminated and patternized after said first metal layer has been laminated and patternized.

6. The method as claimed in claim 4 or 5, characterized in that said etching steps are accomplished by a dry etching.

7. The method as claimed in claim 4, characterized in that the thickness of said first metal layer and said second metal layer are 200nm and 400nm, respectively.

8. The method as claimed in claim 4, characterized in that said p-Al₂O₃ layer is formed by thickness of 500nm, and said Ta₂O₅ layer by thickness of 50nm.

9. The method as claimed in claim 4, characterized in that surfaces of said first metal layer and said second,metal layer,, are anodized in atmosphere of 4% phosphoric acid solution.
